Europäisches Patentamt

European Patent Office

Office européen des brevets

(19)

(11) **EP 0 792 052 A1**

(12) **EUROPEAN PATENT APPLICATION**

(43) Date of publication:
27.08.1997 Bulletin 1997/35

(51) Int. Cl.⁶: **H04L 27/00**, H03D 7/16

(21) Application number: 97103031.7

(22) Date of filing: 25.02.1997

(84) Designated Contracting States:
**DE FR GB IT**

(30) Priority: 26.02.1996 JP 37637/96

(71) Applicant: **NEC CORPORATION**
**Tokyo (JP)**

(72) Inventor: **Miyashita, Toshikazu**
**Minato-ku, Tokyo (JP)**

(74) Representative: **VOSSIUS & PARTNER**
**Siebertstrasse 4**
**81675 München (DE)**

(54) **Local signal generator**

(57)    A local signal generator includes a local oscillator (108) and a frequency divider (109) having a plurality of divisor values. The divider divides the predetermined frequency ($f_{LO2}$) of a reference signal ($S_{LO2}$) by a first divisor value M and a second divisor value N to produce a first local signal ($S_{LR}$) and a second local signal ($S_{LT}$) which are supplied to a demodulator (103) and a modulator (104), respectively. The first divisor value M and the second divisor value N are set by selecting two different ones from the predetermined divisor values so that communication is allowed in a desired communication system.

FIG. 1

EP 0 792 052 A1

## Description

The present invention generally relates to a radio communication apparatus and, in particular, to a local signal generator which generates a pair of local signals of different frequencies for transmission and reception, respectively.

In radio communication circuits, a local oscillator is necessary for frequency conversion, modulation, or demodulation. More specifically, a radio-frequency (RF) reception signal is converted to an intermediate-frequency (IF) reception signal by a frequency converter using an RF local signal for reception and then the IF reception signal is demodulated into a baseband reception signal by a demodulator using an IF local signal for reception. Similarly, a baseband transmission signal is modulated into an IF transmission signal by a modulator using an IF local signal for transmission and then the IF transmission signal is converted to an RF transmission signal by a frequency converter using an RF local signal for transmission. These local signals are preferably generated by a minimum number of local oscillators in order to achieve simplified circuit configuration, especially in the case of a mobile communication apparatus.

In Japanese Patent Unexamined Publication No. 4-355540, a digital radio communication apparatus is disclosed which is provided with a first local oscillator for frequency conversion and a second local oscillator for modulation and demodulation. The second local signal of the second local oscillator is supplied to a modulator and the divided-by-2 signal thereof is supplied to a demodulator. The difference in frequency between the second local signal and the divided-by-2 signal corresponds to the frequency step between transmission and reception channels.

Another conventional circuit is disclosed in Japanese Patent Unexamined Publication No. 4-336715. This circuit includes a frequency divider and a band-pass filter to generate local signals for transmission and reception. The frequency divider divides the oscillation signal of a frequency oscillator to produce a local signal for transmission which is supplied to a modulator. The band-pass filter extracts a local signal for reception from the oscillation signal and its harmonics to output it to a demodulator.

According to these conventional circuits, however, the transmission and reception frequencies and their frequency step are uniquely determined by the local oscillator. Therefore, in the case where the radio communication apparatus is used in another communication system having a different frequency arrangement, it is necessary to replace the local oscillator and the band-pass filter or to previously mount a plurality of local oscillators and band-pass filters for modulation and demodulation.

An object of the present invention is to provide a local signal generator which is capable of easily providing a desired frequency arrangement.

Another object of the present invention is to provide a radio communication apparatus which is usable in different communication systems having different frequency arrangements without replacing any component.

According to the present invention, a circuit is provided with a signal generator and a frequency changer. The signal generator generates a signal of a predetermined frequency. The frequency changer produces a first local signal and a second signal which are used for reception and transmission, respectively, from the signal of the predetermined frequency so that a frequency difference between a first local signal and a second signal is set to a frequency step selected from a plurality of predetermined frequency steps. The frequency changer may be a frequency divider having a plurality of divisor values. The frequency divider divides the predetermined frequency of the signal by a first divisor value M and a second divisor value N to produce a first local signal and a second signal which are used for reception and transmission, respectively. The first divisor value M and the second divisor value N are set by selecting two different ones from the divisor values. The frequency divider may produce a plurality of divided frequencies by dividing the predetermined frequency of the signal by a plurality of predetermined divisor values. From the divided frequencies, the first local signal and the second local signal may be selected by means of a selector, for example, wiring or selective interconnections.

Since a pair of local signals are obtained from a single signal generator, the circuit configuration becomes more simple. Further, since the frequency changer is provided to generate the first local signal and the second signal, the first local signal and the second signal can easily change in frequency so as to be usable for reception and transmission in a plurality of different communication systems without replacing the signal generator. In the case where the divider is provided, by only selecting the first divisor value M and the second divisor value N of the divider, the first local signal and the second signal can easily change in frequency. Therefore, the signal generator and the frequency changer can be shared among different communication apparatuses.

Fig. 1 is a block diagram showing an embodiment of a digital communication apparatus according to the present invention;

Fig. 2 is a block diagram showing a first embodiment of a local signal generator according to the present invention;

Fig. 3 is a block diagram showing a second embodiment of a local signal generator according to the present invention;

Fig. 4 is a block diagram showing a third embodiment of a local signal generator according to the present invention;

Fig. 5 is a block diagram showing a fourth embodiment of a local signal generator according to the present invention;

Fig. 6 is a block diagram showing the detailed circuit of an example of a divider used in each embodiment; and

Fig. 7 is a block diagram showing a general example of a divider used in each embodiment.

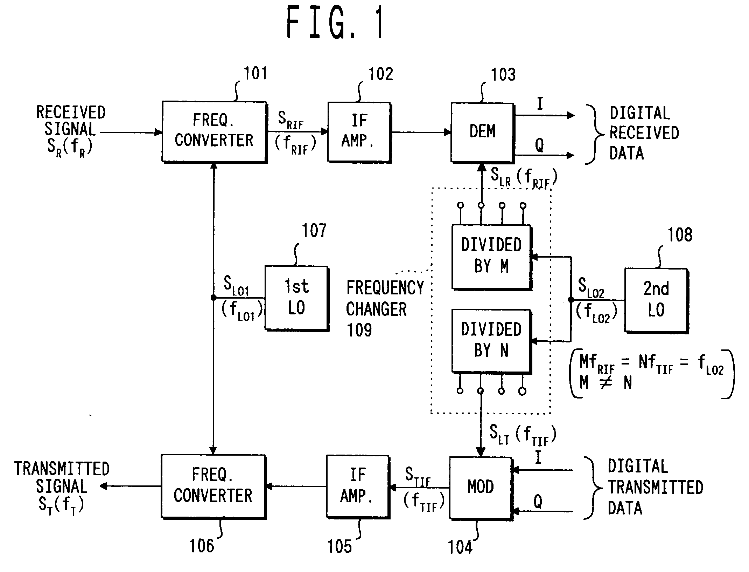

Referring to Fig. 1, a digital communication apparatus is comprised of a reception system and a transmission system. The reception system includes a frequency converter 101, an IF amplifier 102, and a quadrature demodulator 103. A received RF signal $S_R$ of a frequency $f_R$ which is previously determined in a communication network is converted to a received IF signal $S_{RIF}$ of an intermediate frequency $f_{RIF}$ by the frequency converter 101 mixing the received signal $S_R$ with a local signal $S_{LO1}$ of a frequency $f_{LO1}$. After amplified by the IF amplifier 102, the received IF signal $S_{RIF}$ is demodulated by the quadrature demodulator 103 using a first local signal $S_{LR}$ of the frequency $f_{RIF}$ according to a predetermined digital modulation scheme.

The transmission system includes a quadrature modulator 104, an IF amplifier 105, and a frequency converter 106. The quadrature modulator 104 modulates a second local signal $S_{LT}$ of an intermediate frequency $f_{TIF}$ according to digital transmitted data to produce a transmitted IF signal $S_{TIF}$ of the intermediate frequency $f_{TIF}$. After amplified by the IF amplifier 105, the transmitted IF signal $S_{TIF}$ is converted to a transmitted RF signal $S_T$ of a frequency $f_T$ which is previously determined in the communication network by the frequency converter 106 mixing the transmitted IF signal $S_{TIF}$ with the local signal $S_{LO1}$ of the frequency $f_{LO1}$.

The digital communication apparatus further includes a first local oscillator 107, a second local oscillator 108, and a frequency changer 109. The first local oscillator 107 generates the local signal $S_{LO1}$ of the frequency $f_{LO1}$ which is supplied to both the frequency converters 101 and 106. The second local oscillator 108 generates a reference signal $S_{LO2}$ of a frequency $f_{LO2}$ which is output to the frequency changer 109. The frequency changer 109 is provided to change the frequencies of local signals supplied to the demodulator 103 and the modulator 104. The frequency changer 109 divides the frequency $f_{LO2}$ of the reference signal $S_{LO2}$ by two selected values M and N of divisors (M is not equal to N). A divided-by-M local signal $S_{LR}$ of the frequency $f_{RIF}$ and a divided-by-N local signal $S_{LT}$ of the frequency $f_{TIF}$ are supplied to the quadrature demodulator 103 and the quadrature modulator 104, respectively.

The frequency changer 109 is designed to provide a plurality of divisors as will be described in detail. The frequency divisor values M and N are selected from these divisors so as to match the frequency arrangement of the digital communication apparatus to that of a radio communication system. More specifically, the frequency divisor 109 produces a plurality of frequencies which are generated by dividing the frequency $f_{LO2}$ of the reference signal $S_{LO2}$ by the respective divisors. Two different frequencies $f_{RIF}$ and $f_{TIF}$ are selected from these generated frequencies by means of wiring or selective interconnections so that the difference between these frequencies $f_{RIF}$ and $f_{TIF}$ is coincident with that between the radio frequencies $f_R$ and $f_T$.

It is assumed that the first local oscillator 107 generates the frequency $f_{LO1}$ of 980-1005MHz and the second local oscillator 108 generates the frequency $f_{LO2}$ of 90MHz. In this case, when the digital communication apparatus is used in a digital communication system conforming to Global System for Mobile Communication (GSM), that is, the reception frequency $f_R$ of 935-960MHz, the transmission frequency $f_T$ of 890-915MHz, and the reception and transmission channel interval of 45MHz, the divisor values M and N of the divider 109 are set to M = 2 and N = 1. When the digital communication apparatus is used in another digital communication system where the reception frequency $f_R$ is 950-975MHz, the transmission frequency $f_T$ 935-960MHz, and the reception and transmission channel interval of 15MHz, the divisor values M and N of the divider 109 are set to M = 3 and N = 2. Similarly, by only setting the divisor values M and N of the divider 109 to appropriate values, more specifically only changing the wiring or interconnections, the digital communication apparatus may be easily applied to a plurality of different communication schemes. In this embodiment, the frequency changer 109 is provided with a plurality of output terminals corresponding to different divisors, two of which are selected so as to match the predetermined frequency arrangement of the relevant communication system.

It should be noted that the digital communication apparatus may be usable in a larger number of different communication schemes in the case of employing an adjustable-frequency local oscillator as the second oscillator 108.

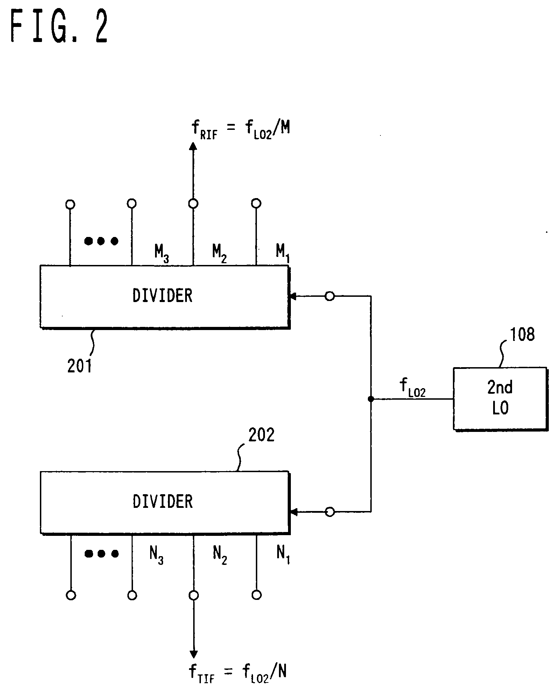

Referring to Fig. 2, the frequency changer 109 may include two dividers 201 and 202 which receive the reference signal $S_{LO2}$ from the second local oscillator 108. Each of the dividers 201 and 202 has a plurality of outputs of different frequencies which are generated by dividing the frequency $f_{LO2}$ of the reference signal $S_{LO2}$ by different divisor values. The frequency $f_{RIF}$ (=$f_{LO2}$/M) is selected from the outputs of the divider 201 and the frequency $f_{TIF}$ (=$f_{LO2}$/N) is selected from the outputs of the divider 202. The dividers 201 and 202 has either the same dividing ratios or different dividing ratios.

In the case of the dividers comprising a plurality of 1/2-dividers connected in series, the divisor values M and N are selected from 1, 2, 4, 8, ..., and $2^K$ (K is the number of output taps). As described before, in the case of GSM system, M=2 and N=1 are selected. In the other case of the divider 201 comprising a plurality of 1/3-dividers connected in series and the divider 202 comprising a plurality of 1/2-dividers connected in series, the divisor value M is selected from 1, 3, 9, 27, ..., and $3^K$ and the divisor value N is selected from 1, 2, 4, 8, ..., and $2^K$. In this embodiment, the divisor values M and N are set by selecting two different output taps of the dividers 201 and 202 by means of wiring.

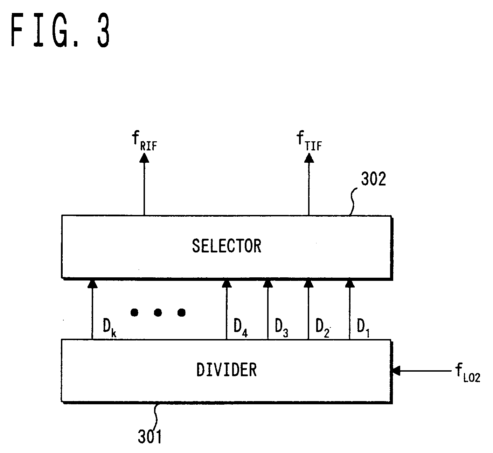

Referring to Fig. 3, the frequency changer 109 may include a divider 301 and a selector 302. The divider 301 receives the reference signal $S_{LO2}$ from the second local oscillator 108 and has a plurality of outputs of different frequencies which are generated by dividing the frequency $f_{LO2}$ of the reference signal $S_{LO2}$ by different divisor values. The selector 302 selects the frequencies $f_{RIF}$ ($=f_{LO2}/M$) and $f_{TIF}$ ($=f_{LO2}/N$) from the outputs of the divider 301. The respective dividing ratios $D_1$-$D_K$ of the divider 301 may be 1/1, 1/2, 1/3, 1/4,..., 1/K. In the case of K=4, the divider 301 may be formed with a combination of two 1/2-dividers and a 1/3-divider. In the case of K=6, the divider 301 may be formed with a combination of three 1/2-dividers, a 1/3-divider and a 1/5-divider. The respective dividing ratios $D_1$-$D_K$ may be 1/1, 1/2, 1/4,..., $1/2^K$ as described above.

The selector 302 is provided wit K input terminals and two output terminals. The respective input terminals receive the dividing ratios $D_1$-$D_K$ and the respective output terminals output the frequencies $f_{RIF}$ ($=f_{LO2}/M$) and $f_{TIF}$ ($=f_{LO2}/N$) to the demodulator 103 and the modulator 104. As described before, in the case of GSM system, two dividing ratios 1/2 and 1/1 are selected. The selector 302 includes selective interconnections which selectively connect between the input terminals and the two output terminals. More specifically, the selector 302 may be a manually-operated selector switch. Alternatively, the selector 302 may be an electrically-operated selector which selects two interconnections according to a control signal received from a processor of the digital communication apparatus. As described before, the two interconnections may be performed by means of wiring.

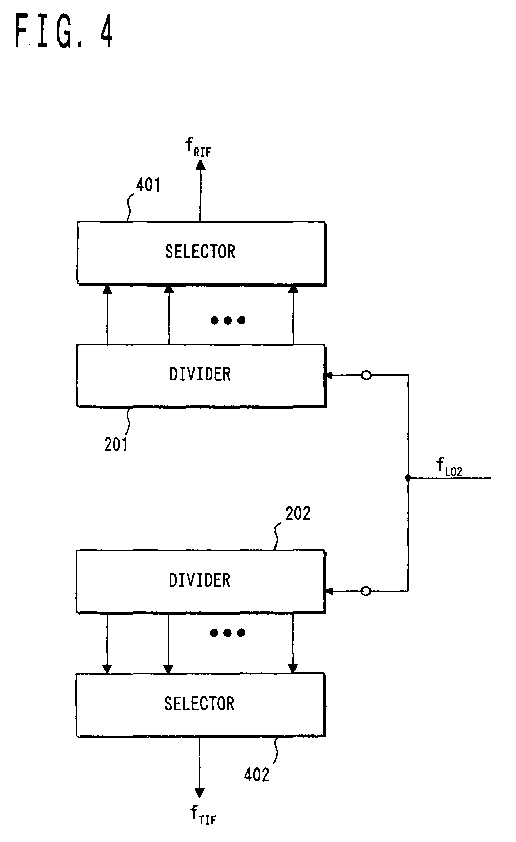

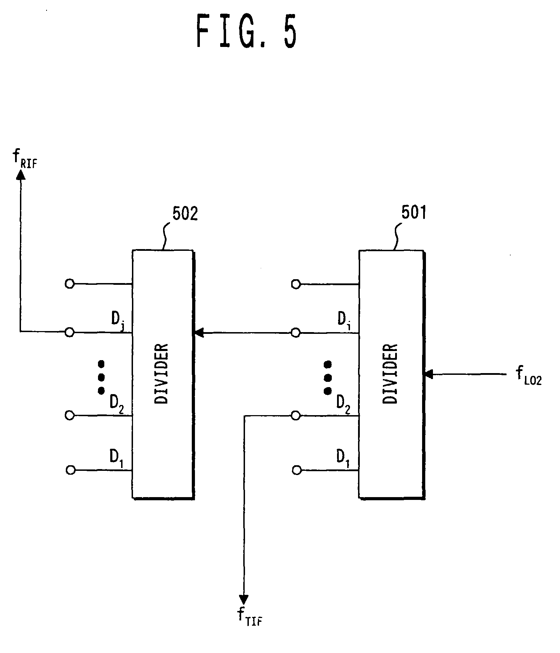

Referring to Fig. 4, the frequency changer 109 may include two dividers 201 and 202 and two selectors 401 and 402 corresponding thereto. The dividers 201 and 202 receive the reference signal $S_{LO2}$ from the second local oscillator 108. Each of the dividers 201 and 202 has a plurality of outputs of different frequencies which are generated by dividing the frequency $f_{LO2}$ of the reference signal $S_{LO2}$ by different divisor values. The frequency $f_{RIF}$ ($=f_{LO2}/M$) is selected from the outputs of the divider 201 by the selector 401 and the frequency $f_{TIF}$ ($=f_{LO2}/N$) is selected from the outputs of the divider 202 by the selector 402. The selectors 401 and 401 are similar to the selector 302 of Fig. 3.

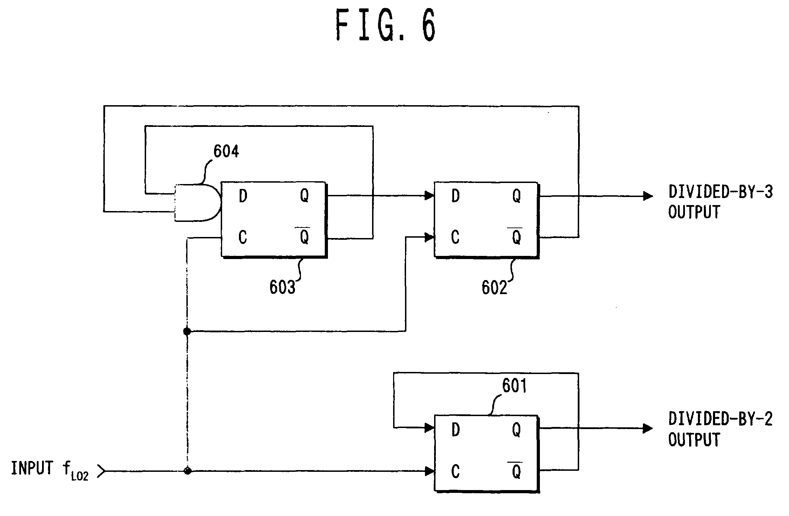

Referring to Fig. 5, the frequency changer 109 may include two dividers 501 and 502 which are connected in series, each of which has a plurality of different dividing ratios. The divider 501 divides the frequency $f_{LO2}$ of the reference signal $S_{LO2}$ by different divisor values. The frequency $f_{RIF}$ ($=f_{LO2}/M$) is selected from the outputs of the divider 501. Further, one of the outputs of the divider 501 is supplied to the divider 502 which divides it by different divisor values. The frequency $f_{TIF}$ ($=f_{LO2}/N$) is selected from the outputs of the divider 502. Needless to say, a selector may be connected to each of the dividers 501 and 502 to select the input of the divider 502, the frequency $f_{RIF}$, and the frequency $f_{TIF}$.

As described above, the frequency changer 109 is formed using a parallel-output divider which outputs a plurality of output signals which are obtained by dividing the frequency $f_{LO2}$ of the reference signal $S_{LO2}$ by divisor values. Such a divider may be implemented by a plurality of different dividers each having a different dividing ratio. The detailed circuit of the divider will be described hereinafter.

Referring to Fig. 6, a parallel-output divider includes a 1/2 divider and a 1/3 divider. The 1/2 divider is comprised of a flip-flop circuit 601 with the inverted output thereof connected to the input. The 1/3 divider is comprised of two flip-flop circuits 602 and 603 and an AND gate 604, where these flip-flop circuits 602 and 603 are connected in series and the respective inverted outputs of the flip-flop circuits 603 and 602 are connected to the inputs of the AND gate 604 whose output is supplied to the input of the flip-flop circuit 603. The frequency $f_{LO2}$ of the reference signal $S_{LO2}$ is supplied as a clock signal to the flip-flop circuits 601-603.

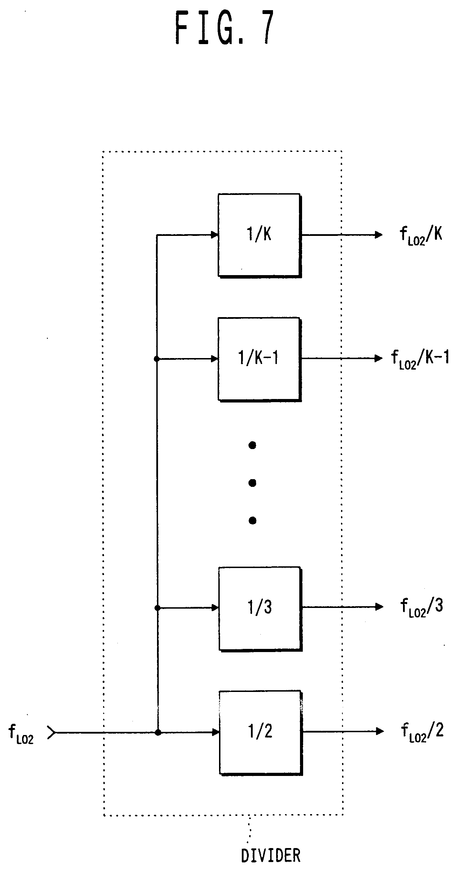

Referring to Fig. 7, the parallel-output divider may be comprised of K dividers having K dividing ratios: 1/2, 1/3, 1/4, ..., 1/K, respectively. These dividers divide the frequency $f_{LO2}$ of the reference signal $S_{LO2}$ by respective divisor values. Employing this parallel-output divider, the different divisor values M and N are selected from 1, 2, 3, ..., K in the above embodiments as shown in Figs. 2-5.

**Claims**

1. A circuit for generating a first local signal ($S_{LR}$) and a second local signal ($S_{LT}$) which are used for reception and transmission, respectively, characterized by:

   a signal generator (108) for generating a signal of a predetermined frequency ($f_{LO2}$); and
   a frequency changer (109) for generating the first local signal and the second local signal from the signal of the predetermined frequency so that a frequency difference between the first local signal and the second local signal is set to a frequency step selected from a plurality of predetermined frequency steps.

2. The circuit according to claim 1, wherein the frequency changer produce the first local signal and the second local signal by dividing the predetermined frequency by a first divisor value M and a second divisor value N, the first divisor value M and the second divisor value N being set by selecting two different ones from a plurality of divisor values.

3. The circuit according to claim 2, wherein the frequency changer comprises:

a frequency divider (201, 202, 301, 501, 502) for dividing the predetermined frequency by a plurality of divisor values to produce divided frequencies, respectively; and
a selector (302, 401, 402) for selecting the first local signal and the second local signal from the divided frequencies.

4. The circuit according to claim 2, wherein the frequency changer comprises:

a first divider (201) for dividing the predetermined frequency of the signal by the first divisor value M to produce the first local signal, the first divider having a plurality of outputs each of which is obtained by dividing the predetermined frequency by a different divisor value, the first divisor value M being set by selecting one of the outputs of the first divider; and
a second divider (202) for dividing the predetermined frequency of the signal by the second divisor value N to produce the second local signal, the second divider having a plurality of outputs each of which is obtained by dividing the predetermined frequency by a different divisor value, the second divisor value N being set by selecting one of the outputs of the second divider.

5. The circuit according to claim 2, wherein the frequency changer comprises a parallel-output divider (301) for dividing the predetermined frequency of the signal by a plurality of divisor values to produce divided signals, respectively, and the first and second local signals being obtained by selecting two different ones from the divided signals.

6. The circuit according to claim 2, wherein the frequency changer comprises:

a first divider (501) for dividing the predetermined frequency of the signal by a plurality of divisor values to produce first divided signals, respectively, one of the first divisor value M and the second divisor value N being set by selecting one of the first divided signals; and
a second divider (502) for dividing one of the first divided signals by a plurality of divisor values to produce second divided signals, respectively, the other of the first divisor value M and the second divisor value N being set by selecting one of the second divided signals.

7. The circuit according to claim 2, wherein the frequency changer includes a selector (302, 401, 402) for selecting the first divisor value M and the second divisor value N.

8. The circuit according to claim 7, wherein the first divisor value M and the second divisor value N are selected by wiring.

9. The circuit according to claim 7, wherein the first divisor value M and the second divisor value N are selected by selective interconnections.

10. The circuit according to claim 3, wherein the frequency divider comprises:

a first divider (201) for dividing the predetermined frequency of the signal by a plurality of first divisor values to produce first divided frequencies, respectively; and
a second divider (202) for dividing the predetermined frequency of the signal by a plurality of second divisor values to produce second divided frequencies, respectively,

the selector comprises:

a first selector (401) for selecting the first local signal from the first divided frequencies; and
a second selector (402) for selecting the second local signal from the second divided frequencies.

11. The circuit according to claim 3, wherein the frequency divider comprises a parallel-output divider (301) for dividing the predetermined frequency of the signal by the divisor values to produce the divided signals, respectively.

12. The circuit according to claim 3, wherein the frequency divider comprises a first divider (501) and a second divider (502); and the selector comprises a first selector and a second selector, wherein the first divider divides the predetermined frequency of the signal by a plurality of first divisor values to produce first divided signals, respectively;

the first selector selects at least one from the first divided signals to produce the first local signal;
the second divider divides a selected one of the first divided signals by a plurality of second divisor values to produce second divided signals, respectively; and
the second selector selects the second signal from the second divided signals.

13. The circuit according to claim 3, wherein the selector selects the first local signal and the second local signal by wiring.

14. The circuit according to claim 3, wherein the selector selects the first local signal and the second local signal by selective interconnections.

15. The circuit according to claim 2, wherein the first divisor value M and the second divisor value N are selected so that transmission and reception using the first local signal and the second local signal are allowed in a desired frequency arrangement.

16. The circuit according to claim 1, further comprising:

  a reception circuit (101, 102, 103) for producing a reception digital signal from a reception signal and the first local signal; and
  a transmission circuit (104, 105, 106) for producing a transmission signal from a transmission digital signal and the second local signal.

17. The circuit according to claim 16, wherein
  the reception circuit comprises a demodulator (103) for demodulating the reception signal using the first local signal to produce the reception digital signal; and
  the transmission circuit comprises a modulator (104) for modulating the second local signal according to the transmission digital signal to produce the transmission signal.

18. The circuit according to claim 17, wherein the reception signal and the first local signal are of a first intermediate frequency, and the transmission signal and the second local signal are of a second intermediate frequency.

19. The circuit according to claim 18, further comprising:

  a first frequency converter (101) for converting a first radio frequency of a radio-frequency reception signal to the first intermediate frequency to produce the reception signal;
  a second frequency converter (106) for converting the second intermediate frequency of the transmission signal to a second radio frequency to produce a radio-frequency transmission signal;
  a first intermediate-frequency amplifier (102) connected between the first frequency converter and the demodulator; and
  a second intermediate-frequency amplifier (105) connected between the second frequency converter and the modulator.

20. The circuit according to claim 2, wherein the frequency changer having a plurality of output terminals corresponding to different dividing ratios from which two different dividing ratios $1/M$ and $1/N$ are selected to produce the first local signal and the second local signal, respectively.

21. A digital communication apparatus comprising:

  a receiver (101, 102) for receiving a radio-frequency reception signal of a first predetermined radio frequency to produce a reception signal of a first intermediate frequency;
  a transmitter (106, 105) for transmitting a radio-frequency transmission signal of a second predetermined radio frequency from a transmission signal of a second intermediate frequency;
  a demodulator (103) for demodulating the reception signal using a first local signal of the first intermediate frequency to produce a reception digital signal; and
  a modulator (104) for modulating a second local signal of the second intermediate frequency according to a transmission digital signal to produce the transmission signal,

  characterized by:

  a local oscillator (108) for generating an oscillation signal of a predetermined frequency; and
  a frequency divider (109) for dividing the predetermined frequency of the oscillation signal by a first divisor value of M (M is an integer) and a second divisor value of N (N is an integer different from M) to produce the first local signal and the second local signal, respectively, the first divisor value M and the second divisor value N being selected from predetermined divisor values of the divider.

22. The digital communication apparatus according to claim 21, wherein the first divisor value M and the second divisor value N are selected so that the radio-frequency reception signal and the radio-frequency transmission signal are usable in a predetermined radio communication system and a frequency difference between the radio-frequency reception signal and the radio-frequency transmission signal is set to a predetermined frequency interval.

23. The digital communication apparatus according to claim 21 or 22, wherein the first divisor value M and the second divisor value N are selected by wiring.

24. The digital communication apparatus according to claim 21 or 22, wherein the first divisor value M and the second divisor value N are selected by selective interconnections.

25. A communication method for generating a first local signal and a second local signal which are used for reception and transmission, respectively, in a communication apparatus, characterize by the steps of:

a) generating a signal of a predetermined frequency; and
b) producing the first local signal and the second local signal from the signal of the predetermined frequency so that a frequency difference between the first local signal and the second local signal is set to a frequency step selected from a plurality of predetermined frequency steps.

26. The method according to claim 25, wherein the step (b) comprises the steps of producing the first local signal and the second local signal by dividing the predetermined frequency by a first divisor value M and a second divisor value N, the first divisor value M and the second divisor value N being set by selecting two different ones from a plurality of divisor values.

27. The method according to claim 26, wherein the step (b) comprises the steps of:

dividing the predetermined frequency by a plurality of divisor values to produce divided frequencies, respectively; and
selecting the first local signal and the second local signal from the divided frequencies.

28. The method according to claim 25, wherein the first divisor value M and the second divisor value N are changed so that a frequency difference between the first local signal and the second local signal is set to another frequency step selected from the predetermined frequency steps.

# FIG. 1

RECEIVED SIGNAL $S_R(f_R)$ → FREQ. CONVERTER (101) → $S_{RIF}$ ($f_{RIF}$) → IF AMP. (102) → DEM (103) → I, Q → DIGITAL RECEIVED DATA

$S_{LR}(f_{RIF})$

1st LO (107), $S_{LO1}$ ($f_{LO1}$)

FREQUENCY CHANGER 109

DIVIDED BY M

DIVIDED BY N

$S_{LO2}$ ($f_{LO2}$), 2nd LO (108)

$$\begin{pmatrix} Mf_{RIF} = Nf_{TIF} = f_{LO2} \\ M \neq N \end{pmatrix}$$

TRANSMITTED SIGNAL $S_T(f_T)$ ← FREQ. CONVERTER (106) ← IF AMP. (105) ← $S_{TIF}$ ($f_{TIF}$) ← MOD (104) ← I, Q ← DIGITAL TRANSMITTED DATA

$S_{LT}$ ($f_{TIF}$)

EP 0 792 052 A1

# FIG. 2

$$f_{RIF} = f_{LO2}/M$$

$M_3$    $M_2$    $M_1$

DIVIDER

201

108

$f_{LO2}$

2nd
LO

202

DIVIDER

$N_3$    $N_2$    $N_1$

$$f_{TIF} = f_{LO2}/N$$

# FIG. 3

$f_{RIF}$      $f_{TIF}$

302

| SELECTOR |
|---|

$D_k$   ● ● ●   $D_4$   $D_3$   $D_2$   $D_1$

| DIVIDER | ← $f_{LO2}$ |
|---|---|

301

# FIG. 4

$f_{RIF}$

401

SELECTOR

● ● ●

DIVIDER

201

$f_{LO2}$

202

DIVIDER

● ● ●

SELECTOR

$f_{TIF}$

402

# FIG. 5

# FIG. 6

INPUT $f_{LO2}$

604

D     Q

C     $\overline{Q}$

603

D     Q

C     $\overline{Q}$

602

DIVIDED-BY-3
OUTPUT

601

D     Q

C     $\overline{Q}$

DIVIDED-BY-2
OUTPUT

EP 0 792 052 A1

# FIG. 7

$$f_{LO2} \rightarrow \boxed{1/K} \rightarrow f_{LO2}/K$$

$$\boxed{1/K-1} \rightarrow f_{LO2}/K-1$$

$$\boxed{1/3} \rightarrow f_{LO2}/3$$

$$f_{LO2} \rightarrow \boxed{1/2} \rightarrow f_{LO2}/2$$

DIVIDER

EP 0 792 052 A1

**European Patent Office**  **EUROPEAN SEARCH REPORT**  Application Number  EP 97 10 3031

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | GB 2 279 519 A (NIPPON ELECTRIC CO) 4 January 1995<br>* page 6, line 41 - line 43; figure 2 *<br>--- | 1 | H04L27/00<br>H03D7/16 |
| X | EP 0 678 974 A (NOKIA MOBILE PHONES LTD) 25 October 1995<br>* page 11, line 12 - line 22 *<br>--- | 1 | |
| X | EP 0 581 573 A (NOKIA MOBILE PHONES LTD) 2 February 1994<br>* page 2, line 18 - line 20 *<br>----- | 1 | |
| | | | TECHNICAL FIELDS SEARCHED (Int.Cl.6)<br><br>H04B<br>H03D |

The present search report has been drawn up for all claims

| Place of search | Date of completion of the search | Examiner |
|---|---|---|
| THE HAGUE | 4 June 1997 | Peeters, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document